# EUROPEAN PATENT APPLICATION

(11) **EP 2 421 056 A2**
(43) Date of publication of application: **22.02.2012**
(21) Application number: 11000357.1
(22) Date of filing: 18.01.2011
(51) Int. Cl.: H01L 31/05

(54) **Solar cell module**

(30) Priority: 17.08.2010 KR 20100079239
(71) Applicant: LG ELECTRONICS INC., Youngdungpo-gu Seoul 150-721 (KR)
(72) Inventor: Hong, Jongkyoung, Seocho-Gu Seoul 137-724 (KR); Kim, Jongdae, Seocho-Gu Seoul 137-724 (KR)
(74) Representative: Katérle, Axel

(57) **Abstract**

A solar cell module is discussed. The solar cell module includes a junction box (300), a solar cell panel including a plurality of strings of solar cells, each string including a plurality of solar cells (110) that are arranged in a row and are electrically connected to one another, an interconnector (120) for electrically connecting adjacent ones of the plurality of solar cells to one another belonging to at least one of the plurality of strings, a first conductive adhesive member (160) positioned between an electrode part of one of the adjacent solar cells and the interconnector, a lead wire (LW) for electrically connecting one end of the interconnector to the junction box, and a second adhesive member (170) positioned between the interconnector and the lead wire. At least one of the interconnector (120) and the lead wire (W) is formed of a lead-free material containing an amount of lead equal to or less than 1,000 ppm.

## Description

This application claims priority to and the benefit of Korean Patent Application No. 10-2010-0079239 filed in the Korean Intellectual Property Office on August 17, 2010, the entire contents of which are incorporated herein by reference.

### BACKGROUND OF THE INVENTION

### Field of the Invention

Example embodiments of the invention relate to a solar cell module in which adjacent solar cells are electrically connected to one another using an interconnector.

### Description of the Related Art

The solar power generation used to convert light energy into electric energy using a photoelectric transformation effect has been widely used as a method for obtaining eco-friendly energy. A solar power generation system using a plurality of solar cell panels has been installed to places, such as houses due to an improvement in a photoelectric transformation efficiency of solar cells.

In a solar cell module, power produced by the solar cells is output to the outside of the solar cell module by connecting a conductive element (for example, an interconnector) connected to an anode and a cathode of each of the solar cells, to lead wires to provide an extension of the conductive element to the outside of the solar cell module and then connecting the lead wires to a junction box to extract a current through a power supply line of the junction box.

### SUMMARY OF THE INVENTION

In one aspect, there is a solar cell module including a junction box, a solar cell panel including a plurality of strings of solar cells, each string including a plurality of solar cells that are arranged in a row and are electrically connected to one another, an interconnector configured to electrically connect adjacent ones of the plurality of solar cells to one another belonging to at least one of the plurality of strings, a first adhesive member positioned between an electrode part of one of the adjacent solar cells and the interconnector, a lead wire configured to electrically connect one end of the interconnector to the junction box, and a second adhesive member positioned between the interconnector and the lead wire, wherein at least one of the interconnector and the lead wire is formed of a lead-free material containing an amount of lead equal to or less than 1,000 ppm.

The first adhesive member and/or the second adhesive member are/is formed of a conductive adhesive film including a resin and a plurality of conductive particles dispersed in the resin.

For example, the first adhesive member is formed of a first conductive adhesive film including a first resin and a plurality of first conductive particles dispersed in the first resin. The second adhesive member is formed of a second conductive adhesive film including a second resin and a plurality of second conductive particles dispersed in the second resin.

When the interconnector and/or the lead wire are/is formed of the lead-free material, it is difficult to perform a soldering process using a flux because of the properties of the lead-free material. Further, because a process temperature rises during a tabbing process, a crack or a bowing phenomenon is generated. Hence, the solar cells may be damaged. An adhesive strength between the elements, on which the tabbing process is performed, for example, between the electrode part and the interconnector or between the interconnector and the lead wire, is therefore reduced.

However, when the elements, on which the tabbing process is performed, are attached to one another using the adhesive member formed of the conductive adhesive film, the problems generated in the soldering process using the flux may be prevented or addressed.

The first conductive adhesive film and the second conductive adhesive film may have the same configuration or different configurations.

The electrode part of each solar cell includes a plurality of front electrodes electrically connected to an emitter layer positioned on a front surface of a substrate of each solar cell. In this instance, the first conductive adhesive film is positioned between the interconnector and the plurality of front electrodes.

The electrode part may further include a plurality of front electrode current collectors that are positioned in a direction crossing the plurality of front electrodes and are electrically and physically connected to the plurality of front electrodes. In this instance, the first conductive adhesive film is positioned between the interconnector and the plurality of front electrode current collectors.

Each solar cell may further include a back electrode positioned on a back surface of the substrate. In this instance, a first conductive adhesive film may be positioned between an interconnector and the back electrode.

Each solar cell may further include a back electrode current collector electrically and physically connected to the back electrode. In this instance, the first conductive adhesive film is positioned between the interconnector and the back electrode current collector.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a plane view of a solar cell module according to an example embodiment of the invention;

FIG. 2 is an exploded perspective view of a solar cell panel shown in FIG. 1;

FIG. 3 is a back view of the solar cell panel shown in FIG. 1;

FIG. 4 is an enlarged view of lead wires shown in FIG. 3;

FIG. 5 is an exploded perspective view illustrating a first example configuration of a solar cell in the solar cell panel shown in FIG. 3;

FIGS. 6 to 12 are cross-sectional views illustrating various assembly configurations of solar cells of the solar cell panel shown in FIG. 5;

FIG. 13 is a cross-sectional view taken along line XIII-XIII of FIG. 3;

FIG. 14 is an exploded perspective view illustrating a second example configuration of a solar cell in the solar cell panel shown in FIG. 3;

FIG. 15 is a cross-sectional view illustrating an assembly configuration of a solar cell in the solar cell panel shown in FIG. 14;

FIGS. 16 and 17 are plane views of a front surface of a substrate of a solar cell illustrating various configurations of a front electrode;

FIGS. 18 and 19 are cross-sectional views illustrating various assembly configurations of a back surface of a substrate of a solar cell in the solar cell panel shown in FIG. 14;

FIGS. 20 to 22 are plane views of a back surface of a substrate of a solar cell illustrating various configurations of a back electrode;

FIG. 23 is an exploded perspective view illustrating a third example configuration of a solar cell in the solar cell panel shown in FIG. 3;

FIG. 24 is a plane view of a back surface of a substrate of a solar cell illustrating a configuration of a back electrode;

FIGS. 25 to 27 are cross-sectional views illustrating various assembly configurations of solar cells of the solar cell panel shown in FIG. 23; and

FIG. 28 is an exploded perspective view illustrating a fourth example configuration of a solar cell in the solar cell panel shown in FIG. 3.

### DETAILED DESCRIPTION OF THE EMBODIMENTS

The invention will be described more fully hereinafter with reference to the accompanying drawings, in which example embodiments of the invention are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

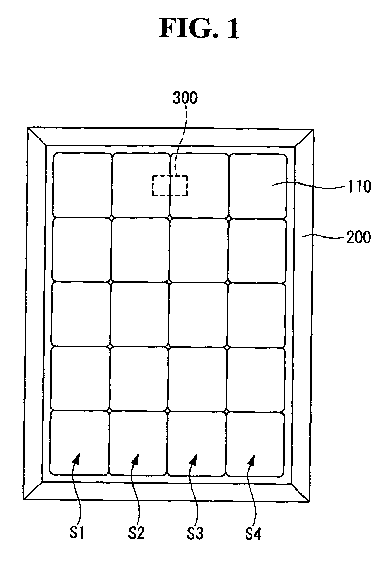

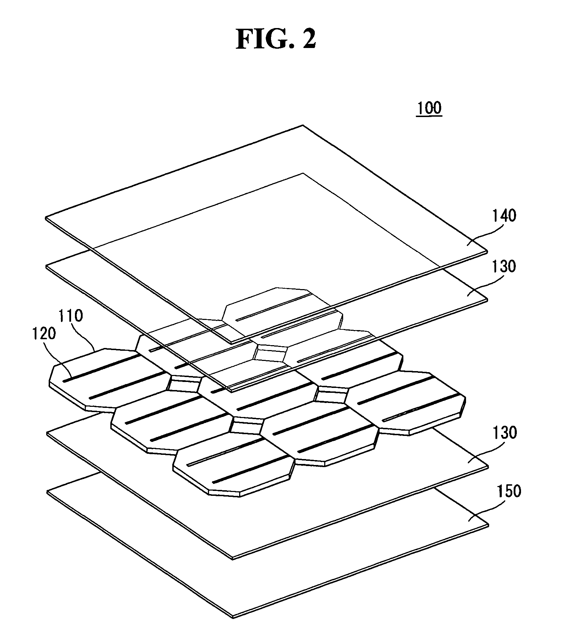

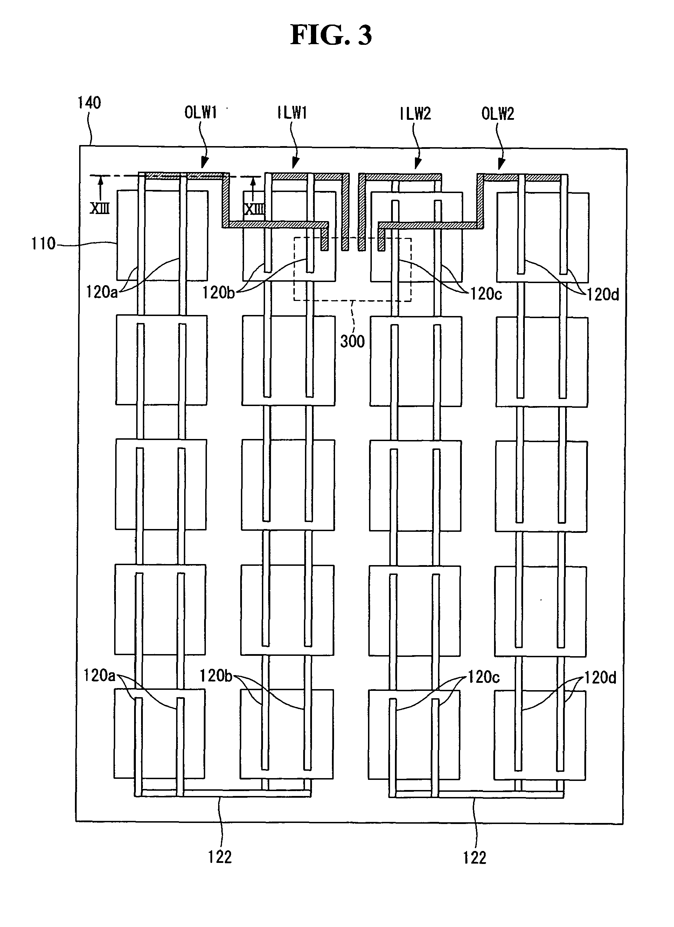

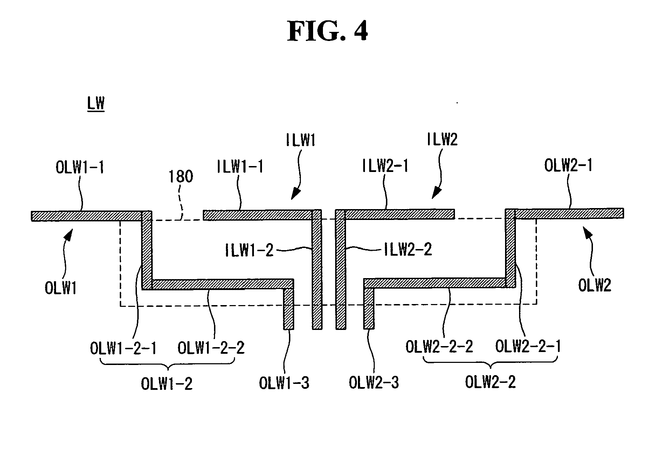

FIG. 1 is a plane view of a solar cell in a solar cell module according to an example embodiment of the invention. FIG. 2 is an exploded perspective view of a solar cell in a solar cell panel shown in FIG. 1. FIG. 3 is a back view of a solar cell in the solar cell panel shown in FIG. 1. FIG. 4 is an enlarged view of lead wires shown in FIG. 3.

A solar cell module according to an example embodiment of the invention includes a solar cell panel 100.

As shown in FIG. 2, the solar cell panel 100 includes a plurality of solar cells 110, interconnectors 120 for electrically connecting the solar cells 110 to one another, protective layers 130 for protecting the solar cells 110, a transparent member 140 positioned on the protective layer 130 on light receiving surfaces of the solar cells 110, and a back sheet 150 that is positioned under the protective layer 130 on surfaces opposite the light receiving surfaces of the solar cells 110 and is formed of an opaque material.

As shown in FIG. 1, the solar cell module includes a frame 200 receiving the components 110, 120, 130, 140, and 150 that form an integral body through a lamination process, and a junction box 300 for collecting power produced by the solar cells 110.

The back sheet 150 prevents moisture or oxygen from penetrating into a back surface of the solar cell panel 100, thereby protecting the solar cells 110 from an external environment. The back sheet 150 may have a multi-layered structure including a moisture/oxygen penetrating prevention layer, a chemical corrosion prevention layer, a layer having insulating characteristics, etc.

The protective layers 130 and the solar cells 110 form an integral body when a lamination process is performed in a state where the protective layers 130 are respectively positioned on and under the solar cells 110. The protective layers 130 prevent corrosion of metal resulting from the moisture penetration and protect the solar cells 110 from an impact. The protective layers 130 may be formed of a material such as ethylene vinyl acetate (EVA). Other materials may be used.

The transparent member 140 on the protective layer 130 is formed of a tempered glass having a high light transmittance and excellent damage prevention characteristic. The tempered glass may be a low iron tempered glass containing a small amount of iron. The transparent member 140 may have an embossed inner surface so as to increase a scattering effect of light.

An electrical connection structure of the solar cell panel of the solar cell module according to the example embodiment of the invention is described in detail below with reference to FIGS. 2 to 4. FIG. 3 depicts an enlarged view of a distance between the solar cells 110. The solar cells 110 are spaced apart from one another at a predetermined distance, for example, a narrow distance equal to or less than about 3 mm.

As shown in FIG. 1, the plurality of solar cells 110 of the solar cell panel 100 is arranged in the string form (or a line form). The string indicates that the plurality of solar cells 110 arranged in a row is electrically connected to one another. Thus, the solar cell panel 100 shown in FIGS. 1 and 3 has four strings, for example, first to fourth strings S1 to S4.

In the example embodiment of the invention, the first and fourth strings S1 and S4 respectively positioned at edges of the solar cell panel 100 are referred to as external strings, and the second and third strings S2 and S3 positioned between the external strings S1 and S4 are referred to as internal strings.

The solar cells 110 arranged in each of the strings S 1 to S4 are electrically connected to one another using the interconnector 120. The interconnector 120 may be formed of a lead-free (or a substantially lead-free) material containing an amount of lead equal to or less than 1,000 ppm.

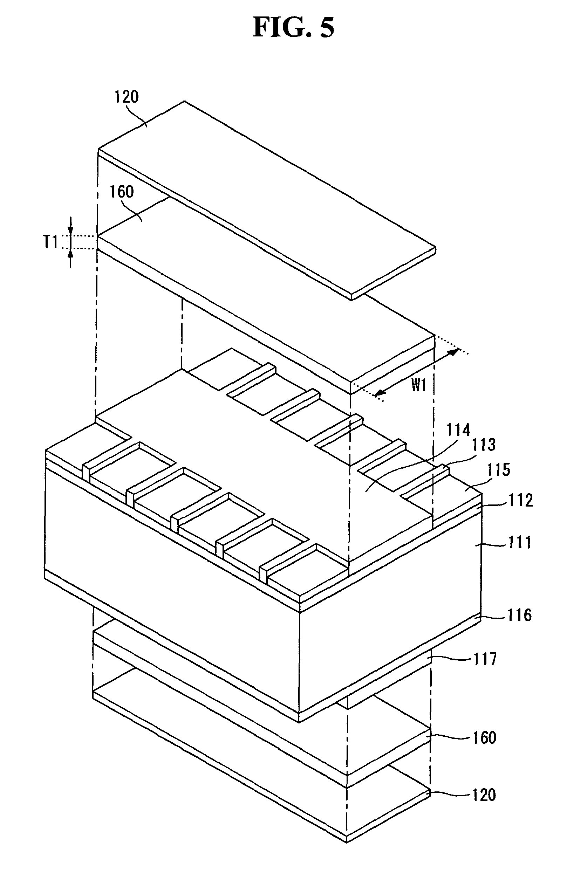

In one string, for example, the first string S1, a front electrode current collector 114 (shown in FIG. 5) of one of the solar cells 110 positioned adjacently to one another in a longitudinal direction is electrically connected to a back electrode current collector 117 (shown in FIG. 5) of another solar cell 110 adjacent to the one solar cell 110 using the interconnector 120.

As shown in FIG. 3, an interconnector 120a positioned under the first string S1 is connected to an interconnector 120b positioned under the second string S2 using another interconnector 122. An interconnector 120c positioned under the third string S3 is connected to an interconnector 120d positioned under the fourth string S4 using the interconnector 122.

The interconnectors 120a, 120b, 120c, and 120d positioned at the top of each of the strings S 1 to S4 are connected to a lead wire LW used to transfer the power generated in the solar cells 110 to the junction box 300. The lead wire LW may be formed of a lead-free (or substantially lead-free) material containing an amount of lead equal to or less than 1,000 ppm.

In the example embodiment of the invention, the lead wires connected to the interconnectors 120a and 120d of the external strings S1 and S4 are referred to as outer lead wires OLW1and OLW2, and the lead wires connected to the interconnectors 120b and 120c of the internal strings S2 and S3 are referred to as inner lead wires ILW1 and ILW2.

The first outer lead wire OLW1 is connected to the interconnector 120a of the first string S1, and the second outer lead wire OLW2 is connected to the interconnector 120d of the fourth string S4. The first inner lead wire ILW1 is connected to the interconnector 120b of the second string S2, and the second inner lead wire ILW2 is connected to the interconnector 120c of the third string S3.

The first and second outer lead wires OLW1 and OLW2 do not overlap the first and second inner lead wires ILW1 and ILW2. Thus, interference is not generated between the first and second outer lead wires OLW1 and OLW2 and the first and second inner lead wires ILW1 and ILW2.

More specifically, as shown in FIG. 4, the first outer lead wire OLW1 includes an interconnector connector OLW1-1 connected to the corresponding interconnector 120a, a connector OLW1-2 whose one end is connected to the interconnector connector OLW1-1, and a junction box connector OLW1-3 connected to the other end of the connector OLW1-2. The second outer lead wire OLW2 includes an interconnector connector OLW2-1 connected to the corresponding interconnector 120d, a connector OLW2-2 whose one end is connected to the interconnector connector OLW2-1, and a junction box connector OLW2-3 connected to the other end of the connector OLW2-2. The first inner lead wire ILW1 includes an interconnector connector ILW1-1 connected to the corresponding interconnector 120b and a junction box connector ILW1-2 connected to one end of the interconnector connector ILW1-1. The second inner lead wire ILW2 includes an interconnector connector ILW2-1 connected to the corresponding interconnector 120c and a junction box connector ILW2-2 connected to one end of the interconnector connector ILW2-1.

The lead wire connected to the interconnector is referred to as a bus ribbon (or a bus bar ribbon) or a bus interconnector (a bus bar interconnector).

In the first and second outer lead wires OLW1 and OLW2, the interconnector connectors OLW1-1 and OLW2-1 are arranged in a direction crossing the corresponding interconnectors 120a and 120d, respectively, and the junction box connectors OLW1-3 and OLW2-3 are arranged in a direction crossing the interconnector connectors OLW1-1 and OLW2-1, i.e., in a direction parallel to the corresponding interconnectors 120a and 120d, respectively.

In the first and second inner lead wires ILW1 and ILW2, the interconnector connectors ILW1-1 and ILW2-1 are arranged in a direction crossing the corresponding interconnectors 120b and 120c, respectively, and the junction box connectors ILW1-2 and ILW2-2 are arranged in a direction crossing the interconnector connectors ILW1-1 and ILW2-1, respectively.

The interconnector connectors OLW1-1 of the first outer lead wire OLW1 and the interconnector connector ILW1-1 of the first inner lead wire ILW1 are arranged in a straight line. The interconnector connectors OLW2-1 of the second outer lead wire OLW2 and the interconnector connector ILW2-1 of the second inner lead wire ILW2 are arranged in a straight line. Further, the interconnector connectors OLW1-1 of the first outer lead wire OLW1, the interconnector connector ILW1-1 of the first inner lead wire ILW1, the interconnector connectors OLW2-1 of the second outer lead wire OLW2, and the interconnector connector ILW2-1 of the second inner lead wire ILW2 are arranged in a straight line.

In the lead wires having the above-described structure, because the interconnector connectors OLW1-1 of the first outer lead wire OLW1, the interconnector connector ILW1-1 of the first inner lead wire ILW1, the interconnector connectors OLW2-1 of the second outer lead wire OLW2, and the interconnector connector ILW2-1 of the second inner lead wire ILW2 are arranged in series, an unnecessary area for arranging the lead wires in the example embodiment of the invention may decrease compared with a related art in which the interconnector connectors are arranged in parallel.

In the first outer lead wire OLW1, the connector OLW1-2 connecting the interconnector connector OLW1-1 to the junction box connector OLW1-3 includes a first connector OLW1-2-1 connected to an end of the interconnector connector OLW1-1 in a direction crossing the interconnector connector OLW1-1 and a second connector OLW1-2-2 connected to the first connector OLW1-2-1 and the junction box connector OLW1-3 in a direction parallel to the interconnector connector OLW1-1. In other words, the first outer lead wire OLW1 has a step shape. In this instance, the end of the interconnector connector OLW1-1 is positioned under an end of the first connector OLW1-2-1, and an end of the junction box connector OLW1-3 is positioned under an end of the second connector OLW1-2-2.

In the second outer lead wire OLW2, the connector OLW2-2 connecting the interconnector connector OLW2-1 to the junction box connector OLW2-3 includes a first connector OLW2-2-1 connected to an end of the interconnector connector OLW2-1 in a direction crossing the interconnector connector OLW2-1 and a second connector OLW2-2-2 connected to the first connector OLW2-2-1 and the junction box connector OLW2-3 in a direction parallel to the interconnector connector OLW2-1. In other words, the second outer lead wire OLW2 has a step shape. In this instance, the end of the interconnector connector OLW2-1 is positioned under an end of the first connector OLW2-2-1, and an end of the junction box connector OLW2-3 is positioned under an end of the second connector OLW2-2-2.

In the first and second inner lead wires ILW1 and ILW2, an end of each of the interconnector connectors ILW1-1 and ILW2-1 is positioned under an end of each of the junction box connectors ILW1-2 and ILW2-2.

In the lead wires having the above-described structure, even if each lead wire is divided into several portions, a height difference of each lead wire may be reduced.

Further, the first outer lead wire OLW1 does not overlap the first inner lead wire ILW1, and the second outer lead wire OLW2 does not overlap the second inner lead wire ILW2. Thus, the interference is not generated between the first and second outer lead wires OLW1 and OLW2 and the first and second inner lead wires ILW1 and ILW2. As a result, an insulating film is not necessary to be formed between the first and second outer lead wires OLW1 and OLW2 and the first and second inner lead wires ILW1 and ILW2.

However, when the interconnector connectors OLW1-1 and OLW2-1 of the outer lead wires OLW1 and OLW2 and the interconnector connectors ILW1-1 and ILW2-1 of the inner lead wires ILW1 and ILW2 are arranged in parallel, an insulating film has to be formed between the outer lead wires OLW1 and OLW2 and the inner lead wires ILW1 and ILW2 so that the interconnector connectors OLW1-2 and OLW2-2 of the outer lead wires OLW1 and OLW2 do not overlap the interconnector connectors ILW1-1 and ILW2-1 of the inner lead wires ILW1 and ILW2.

Accordingly, when the interconnector connectors OLW1-1 and OLW2-1 of the outer lead wires OLW1 and OLW2 and the interconnector connectors ILW1-1 and ILW2-1 of the inner lead wires ILW1 and ILW2 are arranged in a straight line and the outer lead wires OLW1 and OLW2 have the step shape, the insulating film for insulation between the outer lead wires OLW1 and OLW2 and the inner lead wires ILW1 and ILW2 is not necessary to be formed. As a result, the manufacturing cost and the number of manufacturing processes may be reduced.

An insulating film 180 is used to insulate the lead wires OLW1, OLW2, ILW1, and ILW2 from the solar cells 110 and the interconnector. The insulating film 180 has enough size to cover the entire connectors OLW1-2 and OLW2-2 of the outer lead wires OLW1 and OLW2, a portion of each of the junction box connectors OLW1-3 and OLW2-3 of the outer lead wires OLW1 and OLW2, and a portion of each of the junction box connectors ILW1-2 and ILW2-2 of the inner lead wires ILW1 and ILW2, as indicated by the dotted line shown in FIG. 4. The insulating film 180 is positioned in a space between the back surfaces of the solar cells 110 and the lead wires OLW1, OLW2, ILW1, and ILW2.

The insulating film 180 may be formed of an opaque material similar to the back sheet 150 or the same opaque material as the back sheet 150. When the insulating film 180 is formed of the opaque material, only the interconnector connectors OLW1-1, OLW2-1, ILW1-1, and ILW2-1 of the lead wires OLW1, OLW2, ILW1, and ILW2 are observed in the front of the solar cell panel 100. Therefore, an external appearance and insulation characteristic may be improved. In embodiments of the invention, the insulating film 180 may be formed of a transparent material.

Connection structures between electrodes of the solar cells and the interconnector is described below with reference to FIGS. 5 to 12.

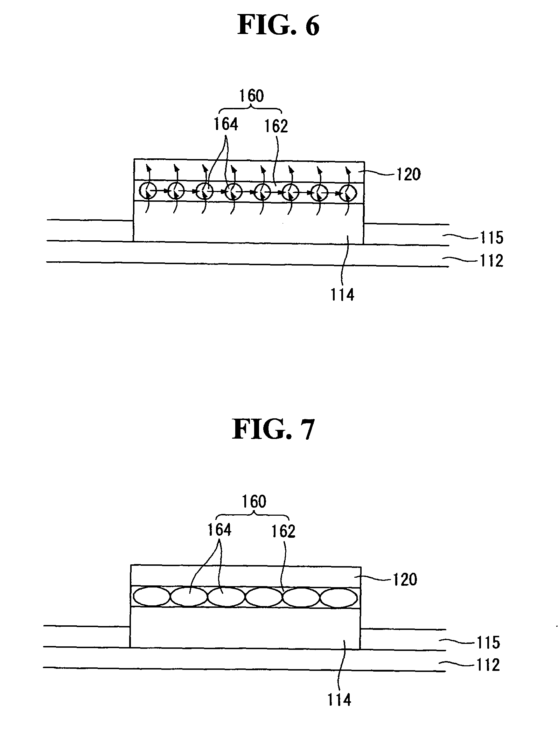

FIG. 5 is an exploded perspective view illustrating a first example configuration of a solar cell in the solar cell panel shown in FIG. 3. FIGS. 6 to 12 are cross-sectional views illustrating various assembly configurations of solar cells of the solar cell panel shown in FIG. 5.

The solar cell 110 according to the example embodiment of the invention includes a substrate 111, an emitter layer 112 positioned on a front surface (i.e., a light receiving surface) of the substrate 111 on which light is incident, a plurality of front electrodes 113 and a plurality of front electrode current collectors 114 positioned on the emitter layer 112, an anti-reflection layer 115 positioned on the emitter layer 112 on which the plurality of front electrodes 113 and the front electrode current collectors 114 are not positioned, and a back electrode 116 and a plurality of back electrode current collectors 117 positioned on a back surface opposite the light receiving surface of the substrate 111.

The solar cell 110 may further include a back surface field (BSF) layer between the back electrode 116 and the substrate 111. The back surface field layer is a region (e.g., a p⁺- type region) that is more heavily doped with impurities of the same conductive type as the substrate 111 than the substrate 111. The back surface field layer serves as a potential barrier of the substrate 111. Thus, because a recombination and/or a disappearance of electrons and holes around the back surface of the substrate 111 are prevented or reduced, the efficiency of the solar cell 110 is improved.

The substrate 111 is a semiconductor substrate, which may be formed of first conductive type silicon, for example, p-type silicon, though not required. Silicon used in the substrate 111 may be single crystal silicon, polycrystalline silicon, or amorphous silicon. When the substrate 111 is of a p-type, the substrate 111 contains impurities of a group III element such as boron (B), gallium (Ga), and indium (In).

The surface of the substrate 111 may be textured to form a textured surface corresponding to an uneven surface or having uneven characteristics. When the surface of the substrate 111 is the textured surface, a light reflectance in the light receiving surface of the substrate 111 is reduced. Further, because both a light incident operation and a light reflection operation are performed on the textured surface of the substrate 111, light is confined in the solar cell 110. Hence, a light absorption increases, and the efficiency of the solar cell 110 is improved. In addition, because a reflection loss of light incident on the substrate 111 decreases, an amount of light incident on the substrate 111 further increases.

The emitter layer 112 is a region doped with impurities of a second conductive type (for example, an n-type) opposite the first conductive type of the substrate 111. The emitter layer 112 forms a p-n junction along with the substrate 111. When the emitter layer 112 is to be of the n-type, the emitter layer 112 may be formed by doping the substrate 111 with impurities of a group V element such as phosphor (P), arsenic (As), and antimony (Sb).

When energy of light incident on the substrate 111 is applied to the semiconductors of the substrate 111, carriers (e.g., electron-hole pairs, for example) are produced inside the semiconductors, and electrons move to the n-type semiconductor and holes move to the p-type semiconductor. Thus, when the substrate 111 is of the p-type and the emitter layer 112 is of the n-type, the holes move to the p-type substrate 111 and the electrons move to the n-type emitter layer 112.

Alternatively, the substrate 111 may be of an n-type and/or may be formed of semiconductor materials other than silicon. When the substrate 111 is of the n-type, the substrate 111 may contain impurities of a group V element such as phosphorus (P), arsenic (As), and antimony (Sb).

Because the emitter layer 112 forms the p-n junction along with the substrate 111, the emitter layer 112 is of the p-type when the substrate 111 is of the n-type. In this instance, electrons move to the n-type substrate 111 and holes move to the p-type emitter layer 112.

When the emitter layer 112 is of the p-type, the emitter layer 112 may be formed by doping a portion of the substrate 111 with impurities of a group III element such as boron (B), gallium (Ga), and indium (In).

The anti-reflection layer 115 on the emitter layer 112 may be formed of silicon nitride (SiNx), silicon dioxide (SiO₂), or titanium dioxide (TiO₂). The anti-reflection layer 115 reduces a reflectance of light incident on the solar cell 110 and increases a selectivity of a predetermined wavelength band of the incident light, thereby increasing the efficiency of the solar cell 110. The anti-reflection layer 115 may have a thickness of about 70 nm to 80 nm. The anti-reflection layer 115 may be omitted, if desired.

The plurality of front electrodes 113 on the emitter layer 112 are electrically and physically connected to the emitter layer 112 and are formed in one direction in a state where the adjacent front electrodes 113 are spaced apart from one another. Each of the front electrodes 113 collects carriers (e.g., electrons) moving to the emitter layer 112. Each of the front electrodes 113 is formed of at least one conductive material. The conductive material may be at least one selected from the group consisting of nickel (Ni), copper (Cu), silver (Ag), aluminum (Al), tin (Sn), zinc (Zn), indium (In), titanium (Ti), gold (Au), and a combination thereof. Other conductive materials may be used for the front electrodes 113.

For example, the front electrodes 113 may be formed of an Ag paste containing lead (Pb). In this instance, the front electrodes 113 may be electrically connected to the emitter layer 112 by way of a process in which the Ag paste is coated on the anti-reflection layer 115 using a screen printing method and the substrate 111 is fired at a temperature of about 750 °C to 800 °C. The electrical connection between the front electrodes 113 and the emitter layer 112 is performed by etching the anti-reflection layer 115 using the lead (Pb) contained in the Ag paste during the firing process and which then brings Ag particles of the Ag paste into contact with the emitter layer 112.

At least two front electrode current collectors 114 are formed on the emitter layer 112 in the direction crossing the front electrodes 113. The front electrode current collectors 114 are electrically and physically connected to the emitter layer 112 and the front electrodes 113. Thus, the front electrode current collectors 114 output carriers (e.g., electrons) transferred from the front electrodes 113 to an external device. The front electrode current collectors 114 are formed of at least one conductive material. The conductive material used for the front electrode current collectors 114 may be at least one selected from the group consisting of Ni, Cu, Ag, Al, Sn, Zn, In, Ti, Au, and a combination thereof. Other conductive materials may be used.

The front electrodes 113 and the front electrode current collectors 114 may be electrically connected to the emitter layer 112 through a punch through operation by way of a process in which the conductive material is applied to the anti-reflection layer 115, patterned, and fired.

The back electrode 116 is formed on the surface (i.e., the back surface of the substrate 111) opposite the light receiving surface of the substrate 111. The back electrode 116 collects carriers (e.g., holes) moving to the substrate 111. The back electrode 116 is formed of at least one conductive material. The conductive material may be at least one selected from the group consisting of Ni, Cu, Ag, Al, Sn, Zn, In, Ti, Au, and a combination thereof. Other conductive materials may be used for the back electrode 116.

The plurality of back electrode current collectors 117 are positioned under the back electrode 116 or on the same surface as the back electrode 116 in a direction crossing the front electrodes 113, for example. The back electrode current collectors 117 are electrically connected to the back electrode 116. Thus, the back electrode current collectors 117 output the carriers (e.g., holes) transferred from the back electrode 116 to the external device. The back electrode current collectors 117 are formed of at least one conductive material. The conductive material may be at least one selected from the group consisting of Ni, Cu, Ag, Al, Sn, Zn, In, Ti, Au, and a combination thereof. Other conductive materials may be used.

A first conductive adhesive film 160 is positioned on the front electrode current collectors 114 in a direction parallel to the front electrode current collectors 114. Further, the first conductive adhesive film 160 is positioned on the back electrode current collectors 117.

FIG. 5 shows that one first conductive adhesive film 160 is positioned on each of the front surface and the back surface of the substrate 111. However, the first conductive adhesive films 160 having the same number as the interconnectors 120 are positioned on each of the front surface and the back surface of the substrate 111.

As shown in FIGS. 6 and 7, the first conductive adhesive film 160 includes a first resin 162 and first conductive particles 164 dispersed in the first resin 162. A material of the first resin 162 is not particularly limited as long as it has the adhesive property. It is preferable, but not required, that a thermosetting resin is used for the first resin 162 so as to increase an adhesive reliability. The thermosetting resin may use at least one selected among epoxy resin, phenoxy resin, acryl resin, polyimide resin, and polycarbonate resin.

The first resin 162 may further contain a predetermined material, for example, a known curing agent and a known curing accelerator other than the thermosetting resin. For example, the first resin 162 may contain a reforming material such as a silane-based coupling agent, a titanate-based coupling agent, and an aluminate-based coupling agent, so as to improve an adhesive strength between the front electrode current collectors 114 and the interconnector 120 and an adhesive strength between the back electrode current collectors 117 and the interconnector 120. The first resin 162 may contain a dispersing agent such as calcium phosphate and calcium carbonate, so as to improve the dispersibility of the first conductive particles 164. The first resin 162 may contain a rubber component such as acrylic rubber, silicon rubber, and urethane rubber, so as to control the modulus of elasticity of the first resin 162.

A material of the first conductive particles 164 is not particularly limited as long as it has conductivity. The first conductive particles 164 may contain at least one metal selected among copper (Cu), silver (Ag), gold (Au), iron (Fe), nickel (Ni), lead (Pb), zinc (Zn), cobalt (Co), titanium (Ti), and magnesium (Mg) as the main component. The first conductive particles 164 may be formed of only metal particles or metal-coated resin particles. The first conductive adhesive film 160 having the above-described configuration may include a peeling film.

It is preferable, but not required, that the first conductive particles 164 use the metal-coated resin particles, so as to mitigate a compressive stress of the first conductive particles 164 and improve a connection reliability of the first conductive particles 164. It is preferable, but not required, that the first conductive particles 164 have a diameter of about 2 µm to 30 µm, so as to improve the dispersibility of the first conductive particles 164.

It is preferable, but not required, that a composition amount of the first conductive particles 164 dispersed in the first resin 162 is about 0.5 % to 20 % based on the total volume of the first conductive adhesive film 160 in consideration of the connection reliability after the first resin 162 is cured.

When the composition amount of the first conductive particles 164 is less than about 0.5 %, a current may not smoothly flow because a physical contact area between the front electrode current collectors 114 and the first conductive adhesive film 160 and a physical contact area between the back electrode current collectors 117 and the first conductive adhesive film 160 decrease. When the composition amount of the first conductive particles 164 is greater than about 20 %, the adhesive strength may be reduced because a composition amount of the first resin 162 relatively decreases.

The first conductive adhesive film 160 is attached to the front electrode current collectors 114 in a direction parallel to the front electrode current collectors 114 and is attached to the back electrode current collectors 117 in a direction parallel to the back electrode current collectors 117.

When a tabbing process is performed using the first conductive adhesive film 160, a heating temperature and a pressure are not particularly limited as long as they are within a range capable of securing an electrical connection and maintaining the adhesive strength.

For example, the heating temperature may be set to a temperature capable of curing the first resin 162, for example, about 140 °C to 180 °C. The pressure may be set to a range capable of sufficiently attaching the front electrode current collectors 114, the back electrode current collectors 117, and the interconnector 120 to the first conductive adhesive film 160. Further, a heating and pressure time may be set to the extent that the front electrode current collectors 114, the back electrode current collectors 117, and the interconnector 120, etc., not are damaged or deteriorated because of heat.

As shown in FIG. 6, the first resin 162 may be positioned between the first conductive particles 164 and the front electrode current collectors 114 and between the first conductive particles 164 and the interconnector 120 in a state where the front electrode current collectors 114 are attached to the interconnector 120 using the first conductive adhesive film 160.

In this instance, carriers moving to the front electrode current collectors 114 jump to the first conductive particles 164 and then again jump to the interconnector 120 as indicated by an arrow shown in FIG. 6. Further, carriers jumping to the first conductive particles 164 may jump to the adjacent first conductive particles 164 as indicated by the arrow shown in FIG. 6. In other words, the carriers moving to the front electrode current collectors 114 move along as indicated by the arrows shown in FIG. 6 and then move to the interconnector 120.

A distance between the first conductive particles 164 may be properly set so that carriers can jump between the adjacent first conductive particles 164. The distance between the first conductive particles 164 may be set by properly adjusting the number or the size of the first conductive particles 164 dispersed in the first resin 162. Thus, the carriers moving to the front electrode current collectors 114 may be transferred to the interconnector 120 through the first conductive particles 164.

Alternatively, the first conductive particles 164 may directly contact one or both of the front electrode current collectors 114 and the interconnector 120.

As shown in FIG. 7, the first conductive particles 164 may directly contact each of the front electrode current collector 114 and the interconnector 120 and may be elastically modified into an oval shape because of the pressure applied during the tabbing process. Thus, as shown in FIG. 5, it is preferable, but not required, that a width W1 of the first conductive adhesive film 160 is greater than a thickness T1 of the first conductive adhesive film 160.

In the structure shown in FIG. 7, because the carriers moving to the front electrode current collectors 114 are directly transferred to the interconnector 120 through the first conductive particles 164, a current in the structure shown in FIG. 7 more smoothly flows than a current in the structure shown in FIG. 6.

As shown in FIG. 7, the adjacent first conductive particles 164 may also physically contact one another, so that the carriers moving to the front electrode current collectors 114 are sufficiently transferred to the interconnector 120. Further, at least two first conductive particles 164 may be positioned on the front electrode current collector 114.

The description of FIGS. 6 and 7 illustrating the connection structure between the front electrode current collectors 114, the first conductive adhesive film 160, and the interconnector 120 may be applied to the connection structure between the back electrode current collectors 117, the first conductive adhesive film 160, and the interconnector 120.

A width of each of the front electrode current collector 114, the first conductive adhesive film 160, and the interconnector 120 may vary.

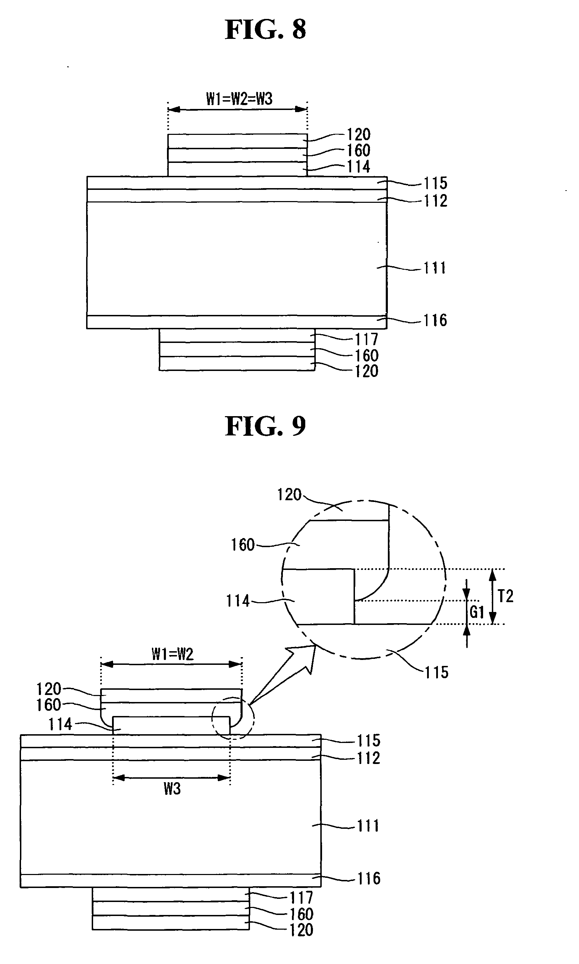

In the example embodiment of the invention, as shown in FIGS. 8 to 12, a width of the first conductive adhesive film 160 is referred to as a first width W1, a width of the interconnector 120 is referred to as a second width W2, and a width of the front electrode current collector 114 is referred to as a third width W3.

As shown in FIGS. 5 and 8, the first width W1 of the first conductive adhesive film 160, the second width W2 of the interconnector 120, and the third width W3 of the front electrode current collector 114 are substantially equal to one another (i.e., W1=W2=W3).

When the tabbing process is performed using the first conductive adhesive film 160, an alignment process may be performed very accurately. Thus, the third width W3 of the front electrode current collector 114 may be equal to or less than about 2.0 mm.

Alternatively, as shown in FIG. 9, the first width W1 and the second width W2 may be substantially equal to each other, and the first width W1 and the second width W2 may be greater than the third width W3. In this instance, the first width W1 and the second width W2 are equal to or less than about 1.5 times the third width W3.

When the first width W1 is greater than the third width W3, a portion of the first conductive adhesive film 160 is attached to a portion of a side surface of the front electrode current collector 114 at a distance G1 from the surface of the substrate 111, i.e., the surface of the anti-reflection layer 115. The distance G1 is equal to or greater than about 0.1 times a thickness T2 of the front electrode current collector 114.

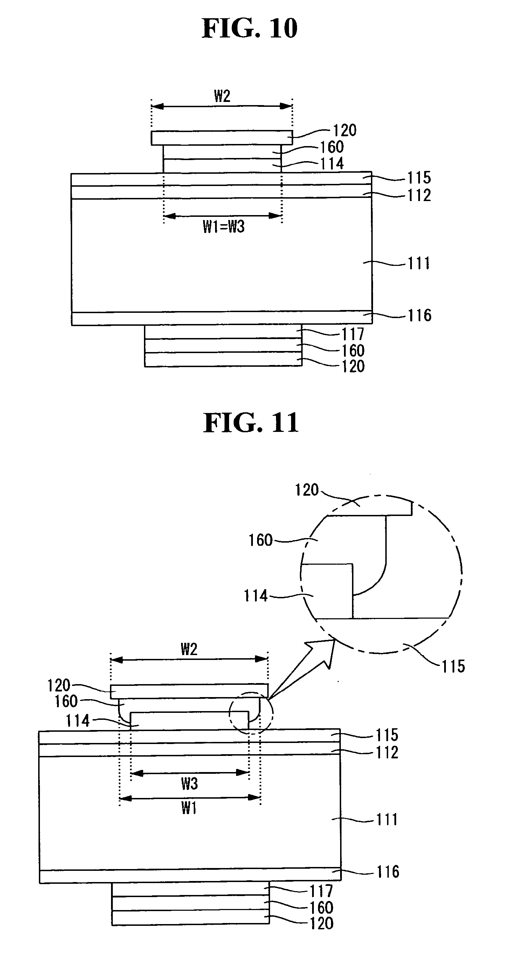

Alternatively, as shown in FIG. 10, the first width W1 may be less than the second width W2 and may be substantially equal to the third width W3. In this instance, the second width W2 is equal to or less than about 1.5 times the first width W1 and the third width W3.

Alternatively, as shown in FIG. 11, the first width W1 may be less than the second width W2 and may be greater than the third width W3. In this instance, the second width W2 is equal to or less than about 1.5 times the first width W1 and the third width W3. Further, a portion of the first conductive adhesive film 160 is attached to a portion of a side surface of the front electrode current collector 114 at the distance G1 from the surface of the substrate 111, i.e., the surface of the anti-reflection layer 115. The distance G1 is equal to or greater than about 0.1 times the thickness T2 of the front electrode current collector 114.

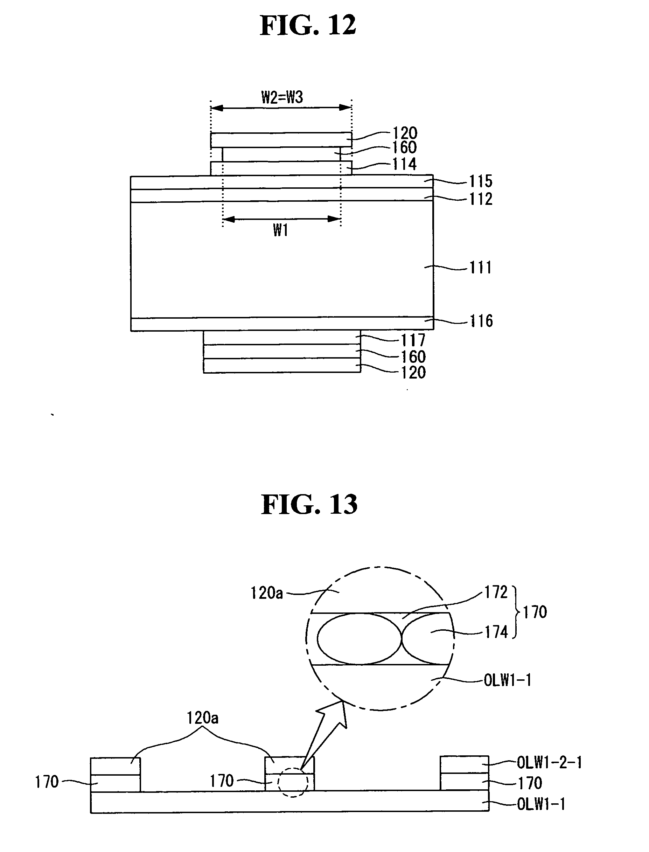

Alternatively, as shown in FIG. 12, the second width W2 may be substantially equal to the third width W3, and the second width W2 and the third width W3 may be greater than the first width W1. In this instance, the second width W2 and the third width W3 are equal to or less than about 1.5 times the first width W1.

Although FIGS. 8 to 12 illustrates a relationship between the first width W1 of the first conductive adhesive film 160, the second width W2 of the interconnector 120, and the third width W3 of the front electrode current collector 114, the technical configuration illustrated in FIGS. 8 to 12 may be applied to a relationship between the first width W1 of the first conductive adhesive film 160, the second width W2 of the interconnector 120, and a width of the back electrode current collector 117.

When the first conductive adhesive film 160 having the above-described structure is used, an attaching operation between the interconnector 120 and the front electrode current collector 114 and an attaching operation between the interconnector 120 and the back electrode current collector 117 are sufficiently performed even if the interconnector 120 is formed of lead-free material.

Shown in FIG. 13 is a cross-sectional view taken along line XIII-XIII of FIG. 3, whereby a second conductive adhesive film 170 is positioned between the interconnector connector OLW1-1 of the lead wire OLW1 and the interconnector 120a. Further, the second conductive adhesive film 170 is positioned between the interconnector connector OLW1-1 and the connector OLW1-2-1 of the lead wire OLW1.

The second conductive adhesive film 170 includes a second resin 172 and second conductive particles 174 dispersed in the second resin 172. The second resin 172 may be formed of the same material as the first resin 162 of the first conductive adhesive film 160, and the second conductive particles 174 may be formed of the same material as the first conductive particles 164 of the first conductive adhesive film 160. Further, the second resin 172 may be formed of a material different from the first resin 162, and the second conductive particles 174 may be formed a material different from the first conductive particles 164.

Thus, even if at least one of the interconnector 120 and the lead wire LW is formed of a lead-free material (or a substantially lead-free material), the tabbing process between the elements to be attached to each other may be efficiently performed.

The above-described example embodiment described that the outer lead wires OLW1 and OLW2 are divided into the interconnector connectors OLW1-1 and OLW2-1, the first connectors OLW1-2-1 and OLW2-2-1, the second connectors OLW1-2-2 and OLW2-2-2, and the junction box connectors OLW1-3 and OLW2-3, respectively, and the inner lead wires ILW1 and ILW2 are divided into the interconnector connectors ILW1-1 and ILW2-1 and the junction box connectors ILW1-2 and ILW2-2, respectively. However, each of the lead wires OLW1, OLW2, ILW1, and ILW2 used in the solar cell module need not be divided and may form an integral body.

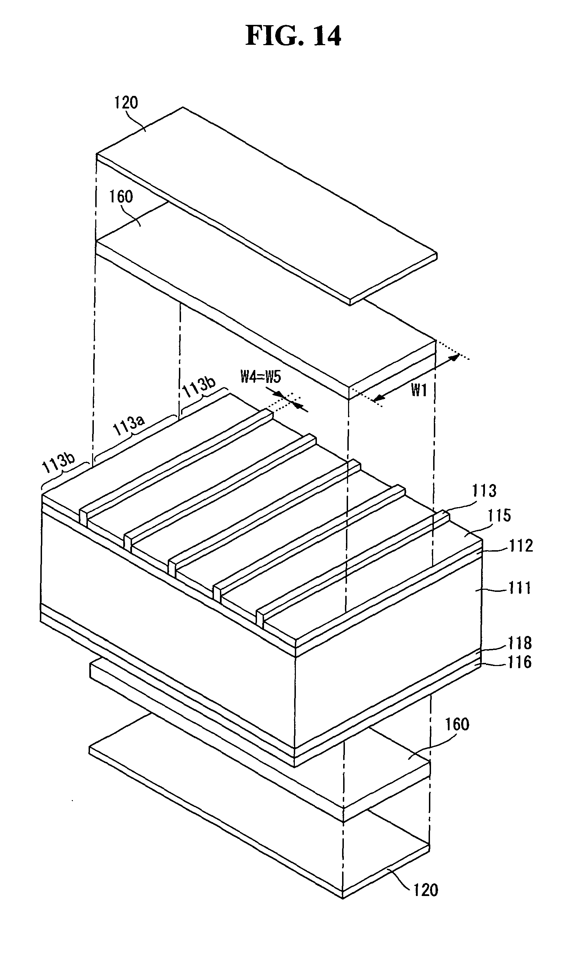

A second example configuration of the solar cell in the solar cell panel shown in FIG. 3 is described below with reference to FIGS. 14 to 22.

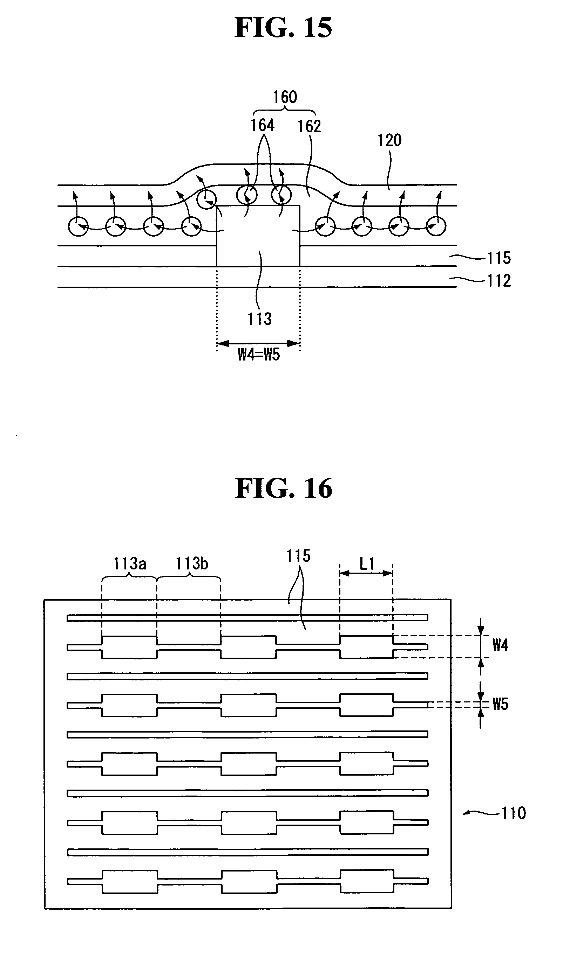

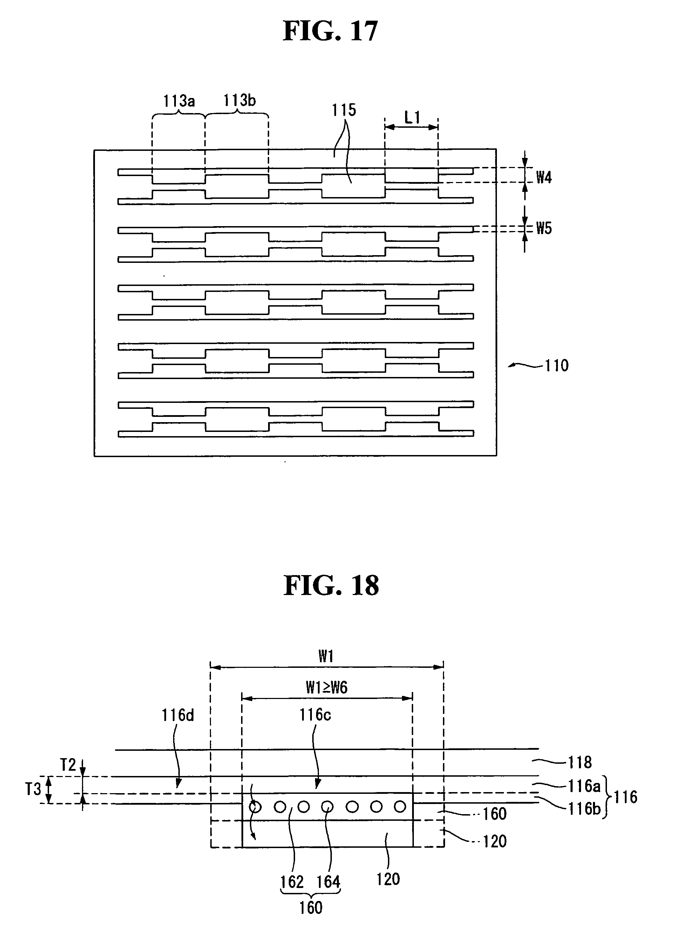

FIG. 14 is an exploded perspective view illustrating a second example configuration of a solar cell in the solar cell panel shown in FIG. 3. FIG. 15 is a cross-sectional view illustrating an assembly configuration of a solar cell in the solar cell panel shown in FIG. 14. FIGS. 16 and 17 are plane views of the front surface of the substrate of a solar cell illustrating various configurations of the front electrode.

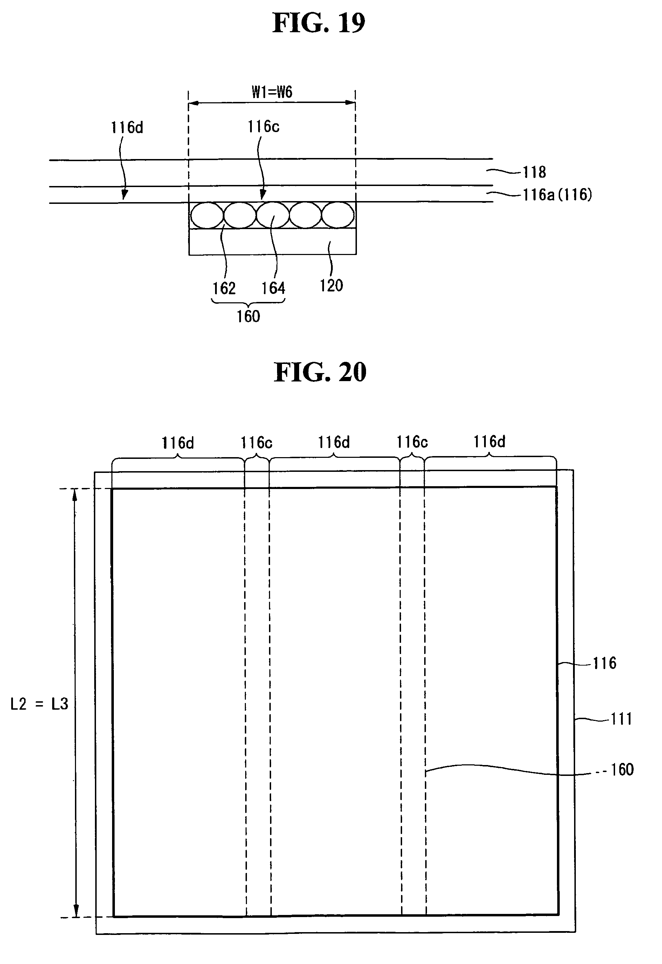

Further, FIGS. 18 and 19 are cross-sectional views illustrating various assembly configurations of the back surface of the substrate of a solar cell in the solar cell panel shown in FIG. 14. FIGS. 20 to 22 are plane views of the back surface of the substrate of a solar cell illustrating various configurations of the back electrode.

In the first example configuration of the solar cell panel 100, the solar cell 110 includes both the front electrode current collector 114 and the back electrode current collector 117. However, in the second example configuration of the solar cell panel 100, the solar cell 110 does not include the front electrode current collector and the back electrode current collector.

More specifically, the solar cell 110 according to the second example configuration of the solar cell panel 100 includes the substrate 111, the emitter layer 112 positioned on the front surface of the substrate 111, the plurality of front electrodes 113 positioned on the emitter layer 112, the anti-reflection layer 115 positioned on the emitter layer 112 on which the plurality of front electrodes 113 are not positioned, the back electrode 116 positioned on the back surface of the substrate 111, and a back surface field (BSF) layer 118 positioned between the back electrode 116 and the substrate 111.

A plurality of first conductive adhesive films 160 are positioned on the emitter layer 112 in a direction crossing the plurality of front electrodes 113. Further, the plurality of first conductive adhesive films 160 are positioned on the back electrode 116 in the direction crossing the plurality of front electrodes 113.

FIG. 14 shows that one first conductive adhesive film 160 is positioned on each of the front surface and the back surface of the substrate 111. Additionally, the same number of first conductive adhesive films 160 as the number of interconnectors 120 is positioned on each of the front surface and the back surface of the substrate 111.

The first conductive adhesive film 160 on the front surface of the substrate 111 is attached to a portion of each front electrode 113 in the direction crossing the plurality of front electrodes 113. Thus, a portion of the first conductive adhesive film 160 directly contacts the portion of each front electrode 113, and a remaining portion of the first conductive adhesive film 160 directly contacts the anti-reflection layer 115. Thus, the first conductive adhesive film 160 is positioned between the front electrodes 113 and the interconnector 120 without an intervening layer, and/or the first conductive adhesive film 160 is positioned between the anti-reflection layer 115 and the interconnector 120 without an intervening layer. Accordingly, plurality of front electrodes 113 respectively have areas that overlap with areas of the first conductive adhesive film 160, and the areas of the respective plurality of front electrodes 113 are thereby also in contact with the areas of the first conductive adhesive film 160. Therefore, areas of the plurality of front electrodes 113 and areas of the first conductive adhesive film 160 that overlap are the same areas of the plurality of front electrodes 113 and areas of the first conductive adhesive film 160 that are in contact.

Each front electrode 113 includes a first portion 113a attached to the first conductive adhesive film 160 and a second portion 113b not attached to the first conductive adhesive film 160.

A portion of the interconnector 120 is attached to a front surface of the first conductive adhesive film 160 attached to the first portion 113a of the front electrode 113 in the same direction as a formation direction of the first conductive adhesive film 160. A remaining portion of the interconnector 120 not attached to the first conductive adhesive film 160 is attached to the back electrode 116 of the adjacent solar cell 110.

The first resin 162 may be positioned between the first conductive particles 164 and the front electrode 113 and between the first conductive particles 164 and the interconnector 120 in a state where the front electrode 113 is attached to the interconnector 120 using the first conductive adhesive film 160.

In this instance, carriers moving to the front electrode 113 jump to the first conductive particles 164 and then again jump to the interconnector 120. Further, carriers jumping to the first conductive particles 164 may jump to the adjacent first conductive particles 164.

A distance between the first conductive particles 164 may be properly set so that carriers can jump between the adjacent first conductive particles 164. The distance between the first conductive particles 164 may be set by properly adjusting the number or the size of the first conductive particles 164 dispersed in the first resin 162.

Thus, the carriers moving to the front electrode 113 are transferred to the interconnector 120 through the first conductive particles 164.

Alternatively, as shown in FIG. 15, the first conductive particles 164 may directly contact one or both of the front electrode 113 and the interconnector 120. In the structure shown in FIG. 15, because the carriers moving to the front electrode 113 are directly transferred to the interconnector 120 through the first conductive particles 164, a current smoothly flows.

A remaining portion of the first conductive adhesive film 160 not attached to the first portion 113a of the front electrode 113 directly contacts the anti-reflection layer 115 on the emitter layer 112.

The first conductive adhesive film 160 may have a thickness greater than a protruding thickness of the front electrode 113, so that the first conductive adhesive film 160 and the interconnector 120 are sufficiently attached to each other. In this instance, because the front surface of the first conductive adhesive film 160 is a flat surface, the first conductive adhesive film 160 and the interconnector 120 are sufficiently attached to each other.

Because a thickness of the front electrode 113 is generally equal to or less than about 15 µm, the protruding thickness of the front electrode 113 is less than about 15 µm. Thus, the thickness of the first conductive adhesive film 160 may be about 15 µm to 60 µm based on specifications of the solar cell to be used in the solar cell panel.

The first conductive adhesive film 160 may have a height difference. The height difference is generated because of the front electrodes 113. When the first conductive adhesive film 160 has the height difference, the interconnector 120 may have the same height difference as the first conductive adhesive film 160. The interconnector 120 may have a portion, whose surface protrudes, because of the first conductive particles 164.

In the structure shown in FIGS. 14 and 15, a width W4 of the first portion 113a of the front electrode 113 may be substantially equal to a width W5 of the second portion 113b of the front electrode 113. Alternatively, the width W4 of the first portion 113a of the front electrode 113 may be different from the width W5 of the second portion 113b of the front electrode 113.

As shown in FIG. 16, the width W4 of the first portion 113a of the front electrode 113 may be greater than the width W5 of the second portion 113b of the front electrode 113. When the width W4 of the first portion 113a is greater than the width W5 of the second portion 113b, an adhesive strength between the first conductive adhesive film 160 and the front electrode 113 is improved, and a contact resistance between the first conductive adhesive film 160 and the front electrode 113 decreases. Hence, an output reduction thereof may be prevented or reduced.

The first portion 113a having the width W4 greater than the width W5 of the second portion 113b may be formed in only the front electrodes 113 positioned on predetermined rows, and the first portion 113a having the same width as the second portion 113b may be formed in the front electrodes 113 positioned on remaining rows. For example, as shown in FIG. 16, each of the front electrodes 113 positioned on even-numbered rows may include the first portion 113a having the width W4 greater than the width W5 of the second portion 113b, and each of the front electrodes 113 positioned on odd-numbered rows may include the first portion 113a having the same width as the second portion 113b.

The first portion 113a having the width W4 greater than the width W5 of the second portion 113b may be formed in only the front electrodes 113 positioned on the odd-numbered rows and/or may have various shapes other than the shape shown in FIG. 16. For example, the various shapes may include a triangle or a semicircle.

The first portion 113a is formed in an up-down symmetric manner based on the front electrode 113 and has a predetermined length L in a longitudinal direction of the front electrode 113. It is preferable, but not required, that the predetermined length L of the first portion 113a is equal to or less than the first width W1 of the first conductive adhesive film 160, so as to improve the adhesive strength between the first conductive adhesive film 160 and the front electrodes 113 and reduce the contact resistance between the first conductive adhesive film 160 and the front electrodes 113.

When the first width W1 of the first conductive adhesive film 160 is less than about 1 mm, the contact resistance increases. When the first width W1 of the first conductive adhesive film 160 is greater than about 20 mm, the light receiving area decreases. Thus, the first width W1 of the first conductive adhesive film 160 may be about 1 mm to 20 mm.

Thus, the predetermined length L of the first portion 113a may be properly set within the range of the first width W1 of the first conductive adhesive film 160 based on specifications or dimensions of the solar cell.

Alternatively, as shown in FIG. 17, each of the front electrodes 113 positioned on all of the rows may include the first portion 113a having the width W4 greater than the width W5 of the second portion 113b.

The adjacent first portions 113a may protrude opposite to each other. The adjacent first portions 113a may protrude in the same direction. In this embodiment of the invention, the first portions 131a extend away from the front electrodes 113, or middle portions thereof, at one side. Thus, along a length of the front electrode 113 in one row, the first portions 113a exists on only one side of the front electrode 113. In the embodiment of the invention shown in FIG. 17, the first portions 113a of adjacent front electrodes 113 face each other. But in other embodiments, the first portions 113a of the adjacent front electrodes 113 may be on the same side, respectively, so that the first portions 113a would all face towards the same side, such as downward or upward, for example. In embodiments of the invention, the first portions 113a are flaps that extend from the front electrodes 113 at one or both sides thereof.

In the example embodiment, the back electrode 116 is formed of aluminum (Al). Thus, the back electrode 116 may be formed by coating an aluminum paste and firing the Al paste.

The aluminum paste used may include an aluminum powder, a bismuth-based glass frit, and an organic vehicle. The aluminum powder has a middle diameter D50 equal to or less than about 10 µm in a particle distribution based on a laser diffraction method. The bismuth-based glass frit contains bismuth oxide as an essential component and has a glass softening temperature equal to or less than about 580 °C.

The aluminum powder refers to an aggregate of particles containing aluminum as the main component and may contain a small amount of impurities other than aluminum.

The middle diameter D50 refers to a diameter when a cumulative volume is 50 % in a particle distribution of the corresponding powder. The middle diameter D50 may be easily measured using various particle distribution measuring devices based on the laser diffraction method.

It is preferable, but not required, that particles constituting the aluminum powder have a sphere shape. However, the particles constituting the aluminum powder may have other shapes such as a flake shape and/or a non-uniform shape.

It is preferable, but not required, that an amount of the aluminum powder is about 65 % to 85 % based on the total amount of the aluminum paste, and an amount of bismuth oxide in the bismuth-based glass fruit is equal to or more than about 40 % based on the total amount of the bismuth-based glass frit.

Examples of the bismuth-based glass frit include a glass frit containing bismuth oxide, boron oxide (B₂O₃), and zinc oxide (ZnO) as the main component, a glass frit containing bismuth oxide, boron oxide (B₂O₃), and silicon oxide as the main component, and a glass frit containing bismuth oxide, silicon oxide, and lead oxide as the main component.

Further, the bismuth-based glass frit may further contain barium oxide (BaO) and silicon dioxide (SiO₂).

An amount of the bismuth-based glass frit may be about 1% to 10 % based on the total amount of the aluminum paste.

The organic vehicle is not particularly limited as long as it can sufficiently disperse the aluminum powder and the bismuth-based glass fruit. The organic vehicle may be at least one of ethylene glycol, diethylene glycol derivative (glycol ether-based derivative), toluene or xylene.

An amount of the organic vehicle may be about 10 % to 30 % based on the total amount of the aluminum paste.

The back electrode 116 may be manufactured or formed by applying the aluminum paste manufactured as discussed above to the back surface of the substrate 111, drying the applied aluminum paste at a proper temperature (for example, a room temperature or 100 °C), and heating (firing) the dried aluminum paste using a firing furnace under the proper heating conditions (for example, at about 700 °C to 800 °C). The back surface field layer 118 is formed simultaneously with the firing of the aluminum paste.

As shown in FIG. 18, when the back electrode 116 is manufactured using the aluminum paste, a high density aluminum layer 116a is formed on the surface of the substrate 111 and a low density aluminum layer 116b is formed on the surface of the high density aluminum layer 116a. Further, an aluminum oxide layer is formed on the surface of the low density aluminum layer 116b. Alternatively, impurities exist at the surface of the low density aluminum layer 116b.

When the aluminum oxide layer or the impurities exist at the surface of the back electrode 116, an adhesive strength between the first conductive adhesive film 160 and the back electrode 116 may be reduced. Thus, before the first conductive adhesive film 160 is attached to the back electrode 116, the surface processing of the back electrode 116 may be performed.

The surface processing of the back electrode 116 may be performed through a cleansing process using a gas (for example, air or an inert gas such as nitrogen gas), pure water or a grinding process using a roller.

When the surface processing of the back electrode 116 is performed, the low density aluminum layer 116b may be removed along with the aluminum oxide layer or the impurities existing at the surface of the back electrode 116.

The first conductive adhesive film 160 is attached to the back electrode 116 having the above-described configuration. The back electrode 116 includes a first portion 116c attached to the first conductive adhesive film 160 and a second portion 116d adjacent to the first portion 116c. Thus, the first conductive adhesive film 160 directly contacts the first portion 116c of the back electrode 116.

The interconnector 120 is attached to a back surface of the first conductive adhesive film 160 attached to the first portion 116c of the back electrode 116 in the same direction as a formation direction of the first conductive adhesive film 160. A remaining portion (or an opposite end) of the interconnector 120 not attached to the first conductive adhesive film 160 is electrically connected to the front electrode 113 of the adjacent solar cell 110.

As shown in FIG. 18, the first resin 162 may be positioned between the first conductive particles 164 and the back electrode 116 and between the first conductive particles 164 and the interconnector 120 in a state where the back electrode 116 is attached to the interconnector 120 using the first conductive adhesive film 160. In an embodiment, the first conductive adhesive film 160 is positioned between the back electrode 116 and the interconnector 120 without an intervening layer. Accordingly, the first conductive adhesive film 160 is directly attached to (or in contact with) the back electrode 116 and the interconnector 120

In this instance, carriers moving to the back electrode 116 jump to the first conductive particles 164 and then again jump to the interconnector 120. Thus, the carriers moving to the back electrode 116 move along as indicated by an arrow shown in FIG. 18 and then move to the interconnector 120.

In this instance, a distance between the first conductive particles 164 may be properly set. The distance between the first conductive particles 164 may be set by properly adjusting the number or the size of the first conductive particles 164 dispersed in the first resin 162.

Thus, the carriers moving to the back electrode 116 are transferred to the interconnector 120 through the first conductive particles 164.

Alternatively, as shown in FIG. 19, the first conductive particles 164 may directly contact one or both of the back electrode 116 and the interconnector 120 and/or to one another.

The first conductive particles 164 may be modified into an oval shape because of the pressure applied during the tabbing process. Thus, it is preferable, but not required, that a width of the first conductive adhesive film 160 is greater than a thickness of the first conductive adhesive film 160.

In the structure shown in FIG. 19, because the carriers moving to the back electrode 116 are directly transferred to the interconnector 120 through the first conductive particles 164, a current in the structure shown in FIG. 19 more smoothly flows than a current in the structure shown in FIG. 18.

The surface processing of the back electrode 116 for removing the aluminum oxide layer and/or the impurities existing at the surface of the back electrode 116 may be performed on only the first portion 116c of the back electrode 116 attached to the first conductive adhesive film 160. The low density aluminum layer 116b on the surface of the high density aluminum layer 116a is removed along with the aluminum oxide layer and/or the impurities.

Thus, as shown in FIG. 18, the first portion 116c of the back electrode 116 is formed of only the high density aluminum layer 116a, and the second portion 116d of the back electrode 116 is formed of the high density aluminum layer 116a, the low density aluminum layer 116b, and the aluminum oxide layer. Therefore, a thickness T2 of the first portion 116c is less than a thickness T3 of the second portion 116d.

When the thickness T2 of the first portion 116c is less than the thickness T3 of the second portion 116d, the width W1 of the first conductive adhesive film 160 may be equal to or less than a width W6 of the first portion 116c as indicated by the solid line shown in FIG. 18 (i.e., W6≥W1). In the structure shown in FIG. 18, the first conductive adhesive film 160 directly contacts the first portion 116c, but does not directly contact the second portion 116d. In this instance, the width W1 of the first conductive adhesive film 160 may be equal to or greater than the width of the interconnector 120. Alternatively, the width W1 of the first conductive adhesive film 160 may be less than the width of the interconnector 120.

Further, the width W1 of the first conductive adhesive film 160 may be greater than the width W6 of the first portion 116c as indicated by the dotted line shown in FIG. 18 (i.e., W1>W6). In this instance, the width W1 of the first conductive adhesive film 160 may be equal to or greater than the width of the interconnector 120. Alternatively, the width W1 of the first conductive adhesive film 160 may be less than the width of the interconnector 120.

Because the aluminum oxide layer existing at the surface of the back electrode 116 is removed even if the back electrode 116 does not include the low density aluminum layer 116b, a slight thickness difference between the first and second portions 116c and 116d may be generated.

As shown in FIG. 19, when the surface processing is performed on the entire surface of the back electrode 116, both the first and second portions 116c and 116d are formed of only the high density aluminum layer 116a. Therefore, the first and second portions 116c and 116d have substantially the same thickness. In this instance, the width W1 of the first conductive adhesive film 160 is substantially equal to the width W6 of the first portion 116c (i.e., W1=W6).

As shown in FIG. 20, the back electrode 116 may be formed on the entire back surface of the substrate 111 except an edge portion (or edge portions) of the substrate 111. In this instance, a length of the first conductive adhesive film 160 may be equal to, slightly shorter than, or slightly longer than a length L2 of the first portion 116c and a length L3 of the second portion 116d.

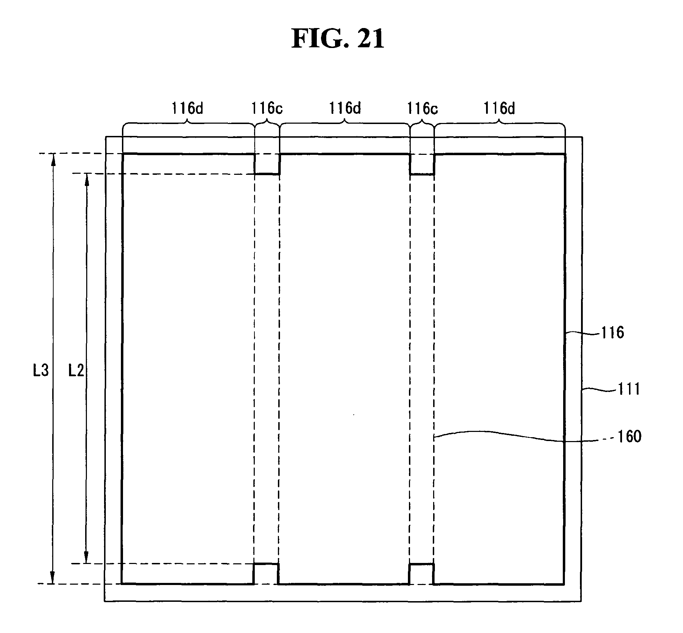

As shown in FIG. 21, the length L2 of the first portion 116c may be shorter than the length L3 of the second portion 116d.

In this instance, because the length of the first conductive adhesive film 160 is longer than the length L2 of the first portion 116c, the adhesive strength may increase by bringing at least one end of the first conductive adhesive film 160 into direct contact with the substrate 111 outside the first portion 116c. Further, the length of the first conductive adhesive film 160 may be substantially equal to the length L3 of the second portion 116d. Additionally, the length of the first conductive adhesive film 160 may be substantially equal to or shorter than the length L2 of the first portion 116c.

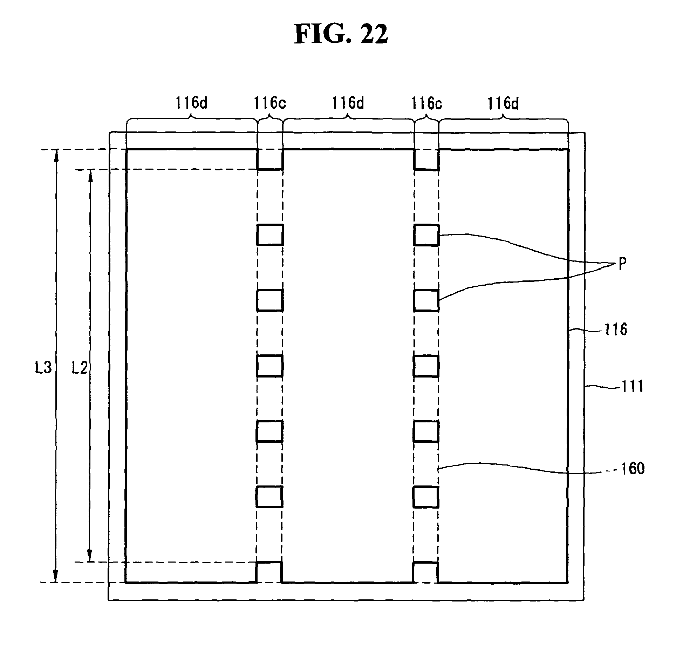

As shown in FIG. 22, hole patterns P exposing the substrate 111 may be formed in one or more portions of the first portion 116c of the back electrode 116. In the structure shown in FIG. 22, because the first conductive adhesive film 160 directly contacts the substrate 111 in the hole patterns P, the adhesive strength of the first conductive adhesive film 160 increases.

FIG. 22 shows the hole patterns P positioned parallel to one another in a row direction, i.e., in a transverse direction in FIG. 22. However, the hole patterns P need not be parallel to one another in the row direction and may be non-uniformly positioned.

In the structure shown in FIG. 22, carriers moving to the back electrode 116 are transferred to the interconnector through the first conductive particles of the first conductive adhesive film 160. Thus, because the back electrode current collector for transferring the carriers moving to the back electrode 116 to the interconnector is not necessary, the process and the cost required to form the back electrode current collector may be reduced or eliminated.

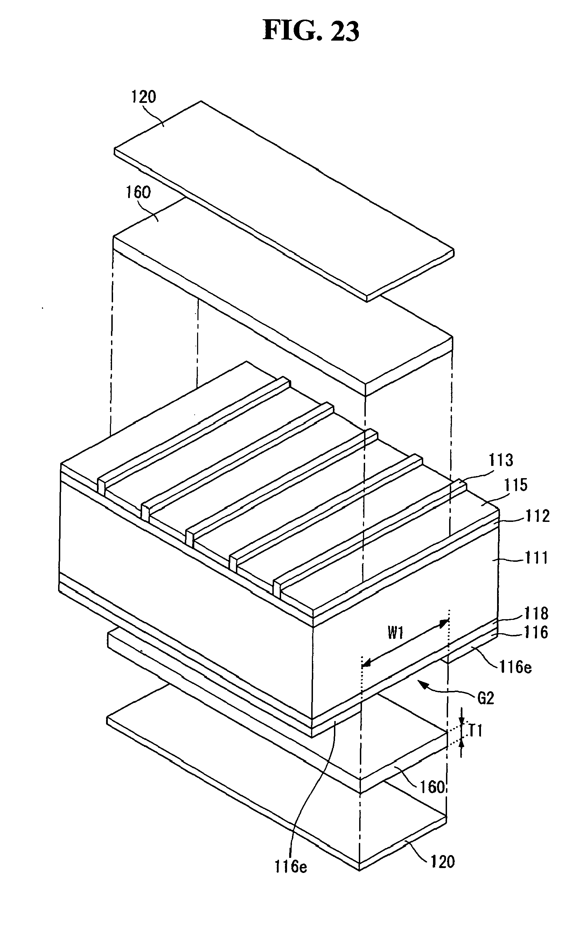

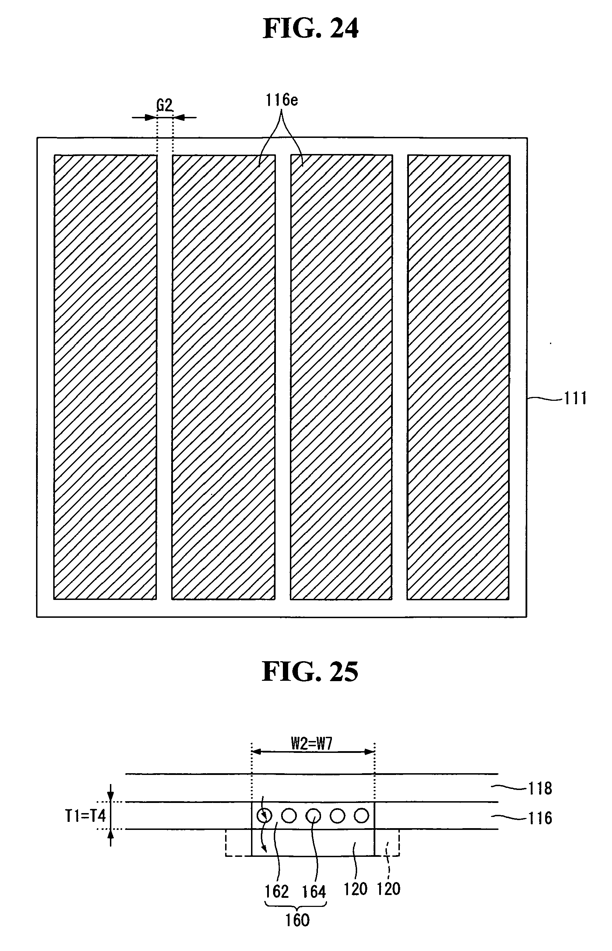

A third example configuration of a solar cell in the solar cell panel is described below with reference to FIGS. 23 to 27. FIG. 23 is an exploded perspective view illustrating a third example configuration of a solar cell in the solar cell panel shown in FIG. 3. FIG. 24 is a plane view of the back surface of the substrate of a solar cell illustrating a configuration of the back electrode. FIGS. 25 to 27 are cross-sectional views illustrating various assembly configurations of solar cells of the solar cell panel shown in FIG. 23.

In the third example configuration of a solar cell in the solar cell panel, as shown in FIGS. 23 and 24, the back electrode 116 includes a plurality of electrode parts 116e that are spaced apart from one another at a space G2. The space G2 may or may not be uniform, and may have a predetermined width. The space G2 exposes the back surface of the substrate 111 so that the first conductive adhesive film 160 directly contacts the back surface of the substrate 111. Because the interconnector 120 is attached to the first conductive adhesive film 160, the number of electrode parts 116e is more than the number of interconnectors 120 by one.

The back electrode 116 including the plurality of electrode parts 116e is formed of at least one conductive material. The conductive material may be at least one selected from the group consisting of nickel (Ni), copper (Cu), silver (Ag), aluminum (Al), tin (Sn), zinc (Zn), indium (In), titanium (Ti), gold (Au), and a combination thereof. Other conductive materials may be used.

The back electrode 116 having the above-described configuration may be manufactured by applying a conductive paste containing the conductive material to the entire back surface of the substrate 111, drying and firing the conductive paste, removing the conductive paste existing in a location to form the first conductive adhesive film 160, and forming the plurality of electrode parts 116e that are spaced apart from one another at the space G2. The edge portion of the back surface of the substrate 111 is excluded in the entire back surface of the substrate 111.

In a method for manufacturing the back electrode 116, impurities are injected inside the substrate 111 during the firing of the conductive paste. Thus, the back surface field layer 118 is formed during the firing of the conductive paste. Because a process for forming the space G2 may be performed after the conductive paste is fired, the back surface field layer 118 may still be formed on the entire back surface of the substrate 111 even in a portion of the back surface of the substrate 111 that is located in the space G2. In an embodiment of the invention, a portion of the back electrode 116 need not be removed, or not formed, for example, so that a single sheet of back electrode 116 exists on the back surface of the substrate 111.

When the back electrode 116 does not include the plurality of electrode parts 116e, it is not easy to attach the first conductive adhesive film 160 to the back surface of the back electrode 116 because of the oxide layer may be formed on the surface of the back electrode 116. Nevertheless, the oxide layer may be removed to enable the first conductive adhesive film 160 to be attached directly to the back surface of the back electrode 116. In such an instance, the first conductive adhesive film 160 is positioned between the back electrode 116 and the interconnector 20 without an intervening layer. Accordingly, the first conductive adhesive film 160 is directly attached to (or in contact with) the back electrode 116 and the interconnector 20.

However, as described above, when the space G2 is formed between the plurality of electrode parts 116e and the first conductive adhesive film 160 is attached to the back surface of the substrate 111 exposed through the space G2, the adhesive strength of the first conductive adhesive film 160 is improved compared with the back electrode 116 not including the electrode parts 116e.

The first conductive adhesive film 160 is attached to the back surface of the substrate 111 exposed through the space G2 formed between the plurality of electrode parts 116e.

The interconnector 120 is attached to the back surface of the first conductive adhesive film 160 attached to the back surface of the substrate 111 in the same direction as a formation direction of the first conductive adhesive film 160. A remaining portion (or another end) of the interconnector 120 not attached to the first conductive adhesive film 160 is electrically connected to the front electrode 113 or the front electrode current collector 114 of the adjacent solar cell 110.

As shown in FIG. 25, the first resin 162 may be positioned between the first conductive particles 164 and the substrate 111 and between the first conductive particles 164 and the interconnector 120 in a state where the interconnector 120 is attached to the substrate 111 using the first conductive adhesive film 160. This may be generated when the thickness T1 of the first conductive adhesive film 160 is substantially equal to or slightly greater than a thickness T4 of the back electrode 116 (i.e., T1≥T4).

However, as described above, even if the first resin 162 is positioned between the first conductive particles 164 and the substrate 111 and between the first conductive particles 164 and the interconnector 120, carriers passing through the back surface field layer 118 may jump to the first conductive particles 164 and then may again jump to the interconnector 120. Thus, the carriers passing through the back surface field layer 118 move along as indicated by the arrow shown in FIG. 25 and then move to the interconnector 120.

In this instance, a distance between the first conductive particles 164 may be properly set. The distance between the first conductive particles 164 may be set by properly adjusting the number or the size of the first conductive particles 164 dispersed in the first resin 162.

The width W2 of the interconnector 120 may be substantially equal to or greater than a width W7 of the space G2 (i.e., W2≥W7). An example where the width W2 of the interconnector 120 is greater than the width W7 of the space G2 is illustrated by the dotted line shown in FIG. 25.

As above, when the width W2 of the interconnector 120 is greater than the width W7 of the space G2, a portion of the interconnector 120 contacts a portion of the electrode part 116e if the thickness T1 of the first conductive adhesive film 160 is equal to the thickness T4 of the back electrode 116.

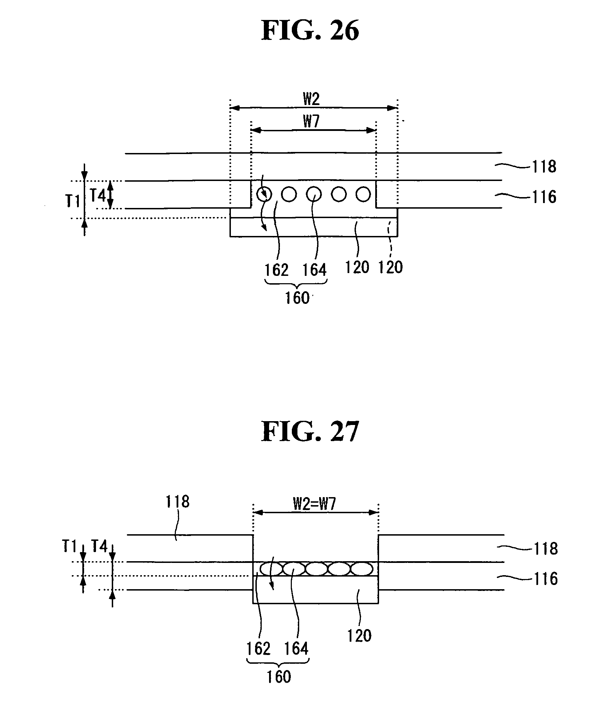

However, as shown in FIG. 26, when the thickness T1 of the first conductive adhesive film 160 is greater than the thickness T4 of the back electrode 116, the first conductive adhesive film 160 may be attached to a portion of the electrode part 116e during the tabbing process. Therefore, in this instance, the interconnector 120, or a portion thereof, does not directly contact the electrode part 116e, and the first conductive adhesive film 160 may be positioned between the interconnector 120 and the electrode part 116e.

Alternatively, as shown in FIG. 27, the first conductive particles 164 may directly contact one or both of the substrate 111 and the interconnector 120 and/or each other. Such may occur when a thickness T1 of the first conductive adhesive film 160 is less than the thickness T4 of the back electrode 116 (i.e., T1<T4).

As above, when the thickness T1 of the first conductive adhesive film 160 is less than the thickness T4 of the back electrode 116, the width W2 of the interconnector 120 may be equal to or less than the width W7 of the space G2 (i.e., W2≤W7), so that the total area of the interconnector 120 sufficiently contacts the first conductive adhesive film 160.

The first conductive particles 164 may be modified into an oval shape because of the pressure applied during the tabbing process as shown in FIG. 27. Thus, it is preferable, but not required, that the width W1 of the first conductive adhesive film 160 is greater than the thickness T1 of the conductive adhesive film 160.

In the structure shown in FIG. 27, because the carriers passing through the back surface field layer 118 are directly transferred to the interconnector 120 through the first conductive particles 164, a current smoothly flows.

The back electrode 116 including the electrode parts 116e may be manufactured using methods other than the above-described method.

For example, the back electrode 116 including the electrode parts 116e may be manufactured using a mask in which the space G2 is formed without separately performing a process for forming the space G2 by removal of a portion of the back electrode 116.

However, in this instance, the back surface field layer 118 formed during the process for firing the conductive paste has the same pattern as the back electrode 116.

In other words, the back surface field layer 118 is formed in only a portion of the substrate 111, on which the electrode part 116e is positioned, and is not formed in a portion of the substrate 111 on which the space G2 is positioned. An example where the back surface field layer 118 is formed in only the portion of the substrate 111 on which the electrode part 116e is positioned is illustrated in FIG. 27.

In the structure shown in FIG. 27, carriers from the substrate 111 are transferred to the interconnector through the first conductive particles of the first conductive adhesive film 160. Thus, because the back electrode current collector is not necessary, the process and the cost required to form the back electrode current collector may be reduced.

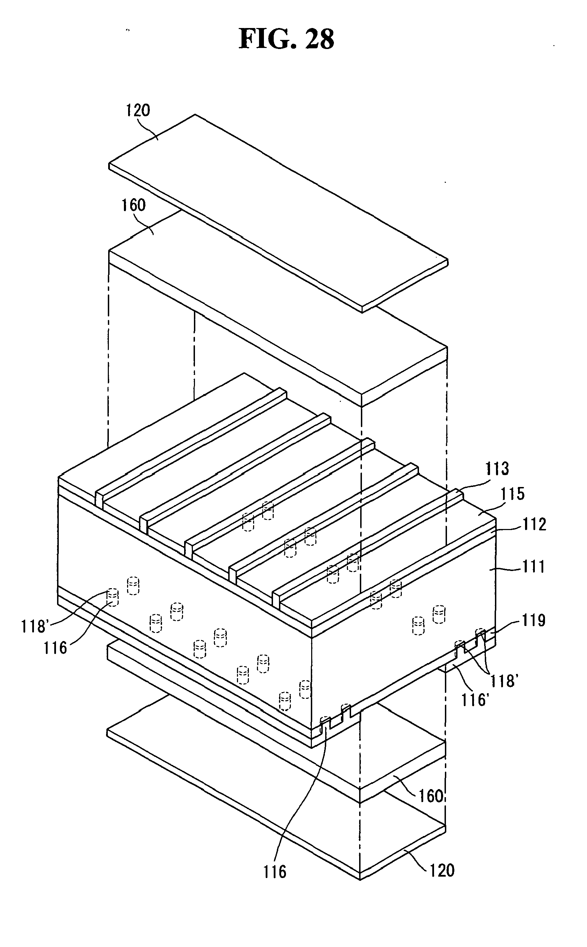

FIG. 28 is an exploded perspective view illustrating a fourth example configuration of a solar cell in the solar cell panel shown in FIG. 3.

In the fourth example configuration of the solar cell panel, a passivation layer 119 is positioned on the back surface of the substrate 111, and a plurality of back electrode conductive layers 116' including the plurality of back electrodes 116 electrically connected to the substrate 111 are positioned on the passivation layer 119. A plurality of back surface field layers 118' are positioned between the back electrode conductive layers 116' and the substrate 111.

The passivation layer 119 on the back surface of the substrate 111 prevents or reduces a recombination and/or a disappearance of carriers around the surface of the substrate 111 and improves an internal reflectance of light passing through the substrate 111, thereby increasing a reincidence rate of light passing through the substrate 111. The passivation layer 119 has a single-layered structure or a multi-layered structure.

The back electrode conductive layers 116' are positioned at areas of the passivation layer 119 that does not have the first conductive adhesive film 160 attached thereto. The back electrode conductive layers 116' may be formed of a conductive material such as aluminum. Other materials may be used.

The back electrode conductive layers 116' have portions that locally pass through the passivation layer 119 and include the plurality of back electrodes 116 that locally are electrically connected to a portion of the substrate 111.

As shown in FIG. 28, the plurality of back electrodes 116 are spaced from one another at a distance, which may be predetermined, for example, at a distance of about 0.5 mm to 1 mm. The back electrodes 116 may have various shapes such as a circle, an oval, and a polygon, for example, in cross section, and may be electrically connected to the substrate 111. Each of the back electrodes 116 may have a stripe shape extending in one direction in the same manner as the front electrode 113. The number of back electrodes 116 having the stripe shape is less than the number of back electrodes 116 having the shape such as the circle, the oval, and the polygon, but such is not required.

The back electrodes 116 collect carriers (for example, holes) moving to the substrate 111 and transfer the carries to the back electrode conductive layers 116'.

A portion of the back electrode 116 contacting the substrate 111 may contain only a formation material of the back electrode conductive layer 116' or may contain a formation material of the passivation layer 119 and a formation material of the substrate 111 as well as the formation material of the back electrode conductive layer 116'.

The back surface field layer 118' between the back electrode 116 and the substrate 111 is a region (e.g., a p⁺-type region) that is more heavily doped with impurities of the same conductive type as the substrate 111 than the substrate 111.

When the back electrode 116 is electrically connected to the substrate 111 and has the stripe shape in the same manner as the front electrode 113, the back surface field layer 118' may have the stripe shape in the same manner as the back electrode 116.

The back electrode 116 and the back surface field layer 118' may be formed by forming the back electrode conductive layers 116' on the passivation layer 119, applying a laser beam in a predetermined area to form a molten mixture of the back electrode conductive layers 116', the passivation layer 119, and the substrate 111, and firing the substrate 111 at a temperature of about 750 °C to 800 °C.

A back electrode current collector may be formed in a space between the back electrodes 116, i.e., on a back surface of the passivation layer 119 to which the first conductive adhesive film 160 is attached.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell module, comprising:
a junction box;
a solar cell panel including a plurality of strings of solar cells, each string including a plurality of solar cells that are arranged in a row and are electrically connected to one another;
an interconnector configured to electrically connect adjacent ones of the plurality of solar cells to one another belonging to at least one of the plurality of strings;
a first adhesive member positioned between an electrode part of one of the adjacent solar cells and the interconnector;
a lead wire configured to electrically connect one end of the interconnector to the junction box; and
a second adhesive member positioned between the interconnector and the lead wire,
wherein at least one of the interconnector and the lead wire is formed of a lead-free material containing an amount of lead equal to or less than 1,000 ppm.

2. The solar cell module of claim 1, wherein the first adhesive member is formed of a first conductive adhesive film including a first resin and a plurality of first conductive particles dispersed in the first resin.

3. The solar cell module of claim 1, wherein the second adhesive member is formed of a second conductive adhesive film including a second resin and a plurality of second conductive particles dispersed in the second resin.

4. The solar cell module of claim 1, wherein the first adhesive member is formed of a first conductive adhesive film including a first resin and a plurality of first conductive particles dispersed in the first resin, and
the second adhesive member is formed of a second conductive adhesive film including a second resin and a plurality of second conductive particles dispersed in the second resin.

5. The solar cell module of claim 4, wherein the first conductive adhesive film is the same as the second conductive adhesive film.

6. The solar cell module of claim 1, wherein the electrode part includes a plurality of front electrodes electrically connected to an emitter layer positioned on a front surface of a substrate of the one of the adjacent solar cells.

7. The solar cell module of claim 6, wherein the first adhesive member is positioned between the interconnector and the plurality of front electrodes.

8. The solar cell module of claim 6, wherein the electrode part further includes a plurality of front electrode current collectors that are positioned in a direction crossing the plurality of front electrodes and are electrically and physically connected to the plurality of front electrodes.

9. The solar cell module of claim 8, wherein the first adhesive member is positioned between the interconnector and the plurality of front electrode current collectors.

10. The solar cell module of claim 6, wherein the one of the adjacent solar cells further includes a back electrode and another interconnector positioned on a back surface of the substrate of the one of the adjacent solar cells.

11. The solar cell module of claim 10, wherein another first adhesive member is positioned between the another interconnector and the back electrode.

12. The solar cell module of claim 10, wherein the one of the adjacent solar cells further includes a back electrode current collector electrically and physically connected to the back electrode.

13. The solar cell module of claim 12, wherein the another first adhesive member is positioned between the another interconnector and the back electrode current collector.

14. The solar cell module of claim 1, wherein the interconnector is formed of the lead-free material containing an amount of lead equal to or less than 1,000 ppm

15. The solar cell module of claim 7, wherein the plurality of front electrodes respectively have areas that overlap with areas of the first adhesive member, and the areas of the respective plurality of front electrodes are also in contact with the areas of the first adhesive member.
